Europäisches Patentamt

European Patent Office

Office européen des brevets

(19)

(11)  EP 1 378 918 A1

(12)  **EUROPEAN PATENT APPLICATION**
published in accordance with Art. 158(3) EPC

(43)  Date of publication:
      **07.01.2004  Bulletin 2004/02**

(21)  Application number: **02700780.6**

(22)  Date of filing: **26.02.2002**

(51)  Int Cl.⁷:  **G21K 1/06**, H01L 21/027

(86)  International application number:
      **PCT/JP2002/001712**

(87)  International publication number:
      **WO 2002/084671 (24.10.2002 Gazette 2002/43)**

(84)  Designated Contracting States:
      **AT BE CH CY DE DK ES FI FR GB GR IE IT LI LU
      MC NL PT SE TR**
      Designated Extension States:
      **AL LT LV MK RO SI**

(30)  Priority:  **11.04.2001  JP 2001113195**

(71)  Applicant: **Nikon Corporation
      Tokyo 100-8331 (JP)**

(72)  Inventors:
      • **KANDAKA, Noriaki, c/o NIKON CORPORATION
        Tokyo 100-8331 (JP)**
      • **YAMAMOTO, Masaki
        Sendai-shi, Miyagi 980-0001 (JP)**

(74)  Representative: **Viering, Jentschura & Partner
      Steinsdorfstrasse 6
      80538 München (DE)**

(54)  **MULTI-LAYERED FILM REFLECTOR MANUFACTURING METHOD**

(57)  A method for manufacturing a multi-layered film reflection mirror, in which a desirable shape precision of a reflective wave front can be obtained after locally scraping the multi-layered film, is provided. The method for manufacturing a multi-layered film reflection mirror according to the present invention, in which a multi-layered film which at least two types of substances having different refractive indices respectively are synchronously deposited. with a constant periodic length is formed on a substrate, and the multi-layered film on the substrate is locally scraped in order to correct a phase of a reflective wave front in a reflective surface, wherein said multi-layered film has an internal stress of 50 MPa or smaller.

*FIG. 1A*

*FIG. 1B*

**Description**

TECHNICAL FIELD

The present invention relates to a method for manufacturing a multi-layered film reflection mirror used to soft X-ray optical apparatuses such as soft X,-ray projection exposure apparatuses.

BACKGROUND ART

Recently, as semiconductor integrated circuits have become smaller in size, in order to improve the resolution of the optical system limited by the boundaries of light diffraction, a projection exposure method utilizing soft X-ray with a wavelength of 11 to 14 nm shorter than a wavelength of ultraviolet light which is conventionally used, has been developed( for instance, as shown in D.Tichenor, et al., SPIE 2437( 1995) 292). Such method is called an EUV( Extreme Ultraviolet) lithography( hereinafter referred to as an EUV lithography in the following). The EUV lithography has been expected for a future lithography technique having a resolution of 70 nm or less, which is impossible of achieving by the conventional lithography using light( a wavelength of 190 nm or more).

Since the refractive indices of materials are nearly 1 in the wavelength band, ordinary optical elements using refraction or reflection cannot be employed. Then, grazing-incidence mirrors which utilize a total reflection of a mirror having a refractive index slightly smaller than 1, or multi-layered film reflection mirrors in which weak rays reflected by many interfaces of the multi-layered film are superimposed in phase in order to obtain a high reflectivity, and the like are utilized. A Mo/Si multi-layered film which a Molybdenum( Mo)-layer and a Silicon (Si)-layer are deposited alternatively enables a reflectivity of 67.5% at a wavelength band in the vicinity of 13.4 nm for perpendicular incidence, or, a Mo/Be multi-layered film which a Mo-layer and a Beryllium ( Be)-layer are deposited alternatively enables a reflectivity of 70.2% at a wavelength band in the vicinity of 11.3 nm for perpendicular incidence( for instance, as shown in C.Montcalm, Proc. SPIE, Vol. 3331( 1998) P. 42).

The EUV lithography apparatus is constructed mainly from a soft X-ray source, an illumination optical system, a mask stage, a focusing optical system, and a wafer stage, and the like. The soft X-ray source utilizes a laser plasma light source, a discharge plasma light source and a radiation light and the like. The illumination optical system is constructed from grazing-incidence mirrors which reflect a soft X-ray incident on the reflective surface from an oblique direction, multi-layered reflection mirrors having a reflective surface made of a multi-layered film, and a filter which transmits a soft X-ray at a predetermined wavelength, and the like, and illuminates on a photomask with a soft X-ray having a predetermined wavelength. Since transparent substance does not exist in the wavelength band of a soft X-ray, a reflective mask is utilized as the photomask instead of the conventionally used transmission mask. Circuit patterns formed on the photomask are focused on a wafer coated with a photoresist by the focusing optical system constituted by a plurality of multi-layered film reflection mirrors and the like, and transferred on the photoresist. Here, a soft X-ray is absorbed in the atmosphere and is attenuated so that all the optical passages are maintained in a predetermined vacuum( for instance, less than $1 \times 10^{-5}$ Torr).

The focusing optical system is constructed from a plurality of multi-layered film reflection mirrors. Since the reflectivities of the multi-layered film reflection mirrors are not 100 %, it is preferable to minimize the number of the mirror in order to suppress a loss of a quantity of light. Until now, an optical system constituting 4 multi-layered film reflection mirrors( for instance, T. Jewell and K.Thompson, USP 5,315,629 and T.Jwell, USP 5,063,586) and an optical system constituting 6 multi-layered film reflection mirrors ( for instance, D.Williamson, Japanese Unexamined Patent Application No Hei 9-211332, USP 5,815,310) and the like has been reported. Unlike a refractive optical system in which luminous flux( pencil of rays) travels to one direction, the reflective optical system in which luminous flux travels to one and the opposite directions in the optical system requires to prevent the shading of luminous flux, so that it is difficult to heighten a numerical aperture( N.A). Although a 4 mirrors optical system enables a N.A. of 0 . 15 at the most , a 6 mirrors optical system makes it possible to constitute an optical system having a N.A. larger than that of 4 mirrors optical system. Generally, a number of the mirrors is even so that the mask stage and the wafer stage can be arranged opposite sides of the exposure focusing optical system. Since it is necessary to correct the aberration of such exposure focusing optical system by using limited number of the mirrors, the surface of each of the reflection mirrors is machined to aspheric. And, the system constitutes a ringfield optical system in which the aberration is corrected only near a predetermined image height In order to transfer the entire pattern formed on the photomask to the wafer, the exposure is carried out with the mask stage and the wafer stage being scanned at a certain speed determined by the magnification of the optical system.

The exposure focusing optical system for the above-described exposure apparatus is so called a diffraction limit optical system and the designed property thereof can be not satisfied unless a wave aberration is sufficiently reduced. As for a target of an allowable value of the wave aberration for the diffraction limit optical system, there is a standard in which the root mean square value( RMS) of the wave aberration is within 1/14 of the wavelength used in the system( as shown in M. Born and E. Wolf, Principles of Optics, 4th edition Pergamon Press 1970, p. 469). This is a condition at which Strehl strength( a ratio of a maximum point intensity of an optical system having an aberration to that of a stigmatic optical system) becomes 80% or more . An exposure focusing optical system practically used for an exposure apparatuses is manufactured to have an aberration less than such value.

The EUV lithography technology which has been developed recently mainly utilizes a wavelength in the vicinity of 13 nm or 11 nm. The figure error (FE) allowable for each of the reflection mirrors for the wave front error( WFE) of the optical system is expressed by the following equation:

$$FE = WFE / 2 / \sqrt{m} \ (RMS)$$

where m is a number of the reflection mirrors constituting the optical system. And, the reason of the division by 2 is that the error of 2 times of the figure error is added to the wave front error because both of the incident light and the reflective light are affected by the figure error respectively. Finally, in the diffraction limit optical system, the figure error( FE) allowable for the each reflection mirror is expressed by the following equation, where $\lambda$ is a wavelength and m is a number of the reflection mirrors:

$$FE = \lambda / 28 / \sqrt{m} \ (RMS).$$

The FE at the wavelength of 13 nm is 0.23nm RMS in the case of the optical system constructed by 4 reflection mirrors, and is 0.19nm RMS in the case of the optical system constructed by 6 reflection mirrors:

However, it is very difficult to manufacture aspheric reflection mirrors. having such high precision, which is the main reason why the EUV lithography can not be in practical use yet. Although the machining accuracy for an aspheric surface, which can be achieved by present, is about 0.4 to 0.5nm RMS( ( as shown in C. Gwyn, Extreme Ultraviolet Lithography White Paper, EUV LLC, 1998, p17), it is necessary to improve a machining technique and a measurement technique for an aspheric surface in order to put the EUV lithography in practical use.

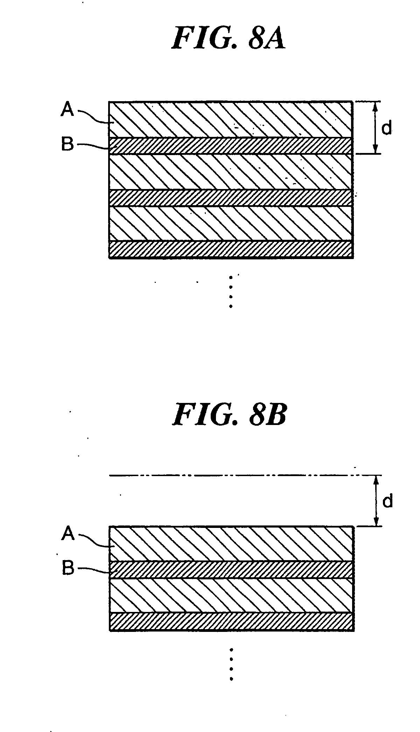

Recently, Yamamoto reported an epoch-making technique which make it-possible to correct the figure error of a multi-layered film reflection mirror by sub nm order by scraping layer by layer from the surface of the multi-layered film reflection mirror ( as shown in M. Yamamoto, 7th International Conference on Synchrotron Radiation Instrumentation, Berlin Germany, August 21-25, 2000, POS2-189). The principle of the technology will be explained referring to Fig. 8. Supposing the case that from a surface of a multi-layered film which two types of substances A and B are deposited alternately with a periodic length of d, as shown in Fig.8A, one layer pair is scraped off, as shown in Fig. 8B . In Fig. 8A, the optical path length of one layer pair having a thickness of d along a light beam perpendicularly incident to the surface of the multi-layered film is expressed by OP = nAdA+nBdB. Where dA and dB are thicknesses of the layers respectively, and dA + dB = d. And, nA and nB are refractive indices of the substances A and B respectively. As shown in Fig.8B, the optical path length of a part having a thickness of d, in which one layer pair is scraped from the most upper surface of the multi-layered film, is expressed by OP' = nd. Where n is a refractive index in vacuum, here n is 1. Accordingly, an optical pass length of an incident light beam to the scraped part varies by scraping the most upper layer from the multi-layered film. This is optically equivalent to modify the surface shape by the variation in the optical length. The variation in the optical path length( that is, the variation in the surface shape) is expressed by $\varDelta$ = OP' - OP. Since the refractive index of substance is nearly 1 at a wavelength band of the soft X-ray, the $\varDelta$ becomes small value so that the surface shape can be precisely corrected by using the present method. For instance, the case that a Mo/Si multi-layered film is used at a wavelength of 13.4 nm is shown. For the perpendicular incidence, d is 6.8 nm, dMo is 2.3 nm, and dSi is 4. 5 nm. At the wavelength band, the refractive index ( nMo) of Mo is 0.92 and the refractive index( nSi) of Si is 0.998. On calculation of a variation in a optical path length by using these values, OP is 6.6 nm, OP' is 6.8 nm, and $\varDelta$ is 0 . 2 nm. By scraping one layer having a thickness of 6.8nm, the surface shape can be modified with a precision of 0.2 nm. Incidentally, in the case of a Mo/Si multi-layered film, since the refractive index of the Si layer is nearly 1, the variation in the optical path length is mainly dependent on existence or non-existence of the Mo layer and independent on existence or non-existence of the Si layer. Accordingly, when the most upper layer is scraped from the multi-layered film, there is no necessary to control the thickness of the Si layer precisely. In this case, the thickness of the Si layer is 4.5 nm and the scraping process may be stopped on the processing way of the Si layer. This means that processing with a precision of several nm enables to correct the surface shape by 0.2 nm order.

Practically, a reflective wave front is measured after forming a multi-layered film, and an amount of the scraped multi-layered film from.the most upper. surface/ thereof is determined based on the result of the measurement, followed by the scraping process.

Here, the reflectivity of the multi-layered film is increased as the number of layers of the deposited film increases, and is saturated to be constant beyond a given number of the deposited film. When the number of the layers of the deposited films is given so that the reflectivity is saturated enough, the reflectivity will not change even if the multi-layered film is scraped.

In general, a multi-layered film has an internal stress, so a Mo/Si film and a Mo/Be film used for EUV lithography also has an internal stress. For instance, it is reported that a Mo/Si multi-layered film has a compressive stress of about -450 MPa and a Mo/Be film has a tensile stress of about +400 MPa( P.B.Mirkarini et. al. Proc. SPIE 3331 pp. 133-148 ( 1998)). In the EUV lithography technique, an internal stress in a multi-layered film considerably-influences a : shape of a substrate surface on/which the multi-layered film is formed.

As described above, a shape precision required to the reflection mirrors for the exposure optical system used for the EUV lithography is 0 . 23 to 0.19 nm RMS or less. Even if the substrate of the mirror for the exposure optical system can be processed to have such shape precision, when a conventional Mo/Si multi-layered film or Mo/Be multi-layered film is formed on the substrate, the shape of the substrate is deformed due to the internal stress in the formed multi-layered film. The deformation amount which varies by the shape of the substrate considerably exceeds the required shape precision.

For instance, when a Mo/Si multi-layered film ( periodic length is 7.0 nm, $\Gamma$ is 0.35, 50 layer pair) having an internal stress of -400 MPa is formed on one surface of a substrate made of crystal having a diameter of 200 mm and a thickness of 40 mm, the amount of the deformation in the substrate caused by the formed film exceeds 10 nm. Here, $\Gamma$ is a division ratio of a layer structure unit, which shows a ratio of a thickness of a substance having a larger absorptance to a periodic length. Here, it is a ratio of a thickness of the Mo layer to the periodic length of 7.0 nm. The influence of the component which contributes the variation in the radius of curvature of the substrate among the deformation components, which produces , can be modulated by adjusting the distance between the mirrors with maintaining the influence for the imaging property small. However, the deformation component impossible of being modulated by adjusting the distance between the mirrors is 1 nm or more thereby to considerably influence optical characteristics of the EUV lithography. Therefore, it is thought that the absolute value of the stress in a multi-layered film has to be suppressed less than 50 MPa.

In order to solve the problem, methods for reducing the stress in the multi-layered film are proposed, in which the deposit structure unit is a Mo/Ru/Mo/Si structure instead of a Mo/Si structure and an ion beam is irradiated on the surface after forming each Mo layer ( M. Shiraishi et. al. Proc. SPIE 3997 pp. 620-627 ( 2000)), and in which the substrate is heated at the film forming, and the like. The former stress reducing method proposed by Shiraishi et.al. reports that the stress in the multi-layered film is reduced to + 14 MPa( tensile stress).

And, another methods are also proposed, in which a Mo/Be multi-layered film having a certain tensile stress is pre-formed in order to cancel a deformation caused by a compressive stress in a Mo/Si multi-layered film, resulted in canceling both stress after forming the multi-layered film( P.B. Mirkarini et . al. Proc. SPIE 3331 pp. 133-148( 1998)), in which a multi-layered film is also formed on a back surface of the substrate to cancel the deformations, and in which, based on the deformation caused by the stress of the multi-layered film, a substrate is machined to a shape which predicted to be a target shape after the deformation caused by the formed multi-layered film.

Although the method for controlling the reflective wave front proposed by Yamamoto et.al. is very useful, according to the proposal, the multi-layered film is locally scraped off so that the thickness of the multi-layered film becomes uneven on the surface of the substrate. As described above, since a multi-layered film has a internal stress of about several 100 MPa in general, if the multi-layered film is locally scraped off , the total stress (stress × thickness) in the multi-layered film on the surface before the scraping process is different from that after the scraping process so that the shape of the substrate is deformed.

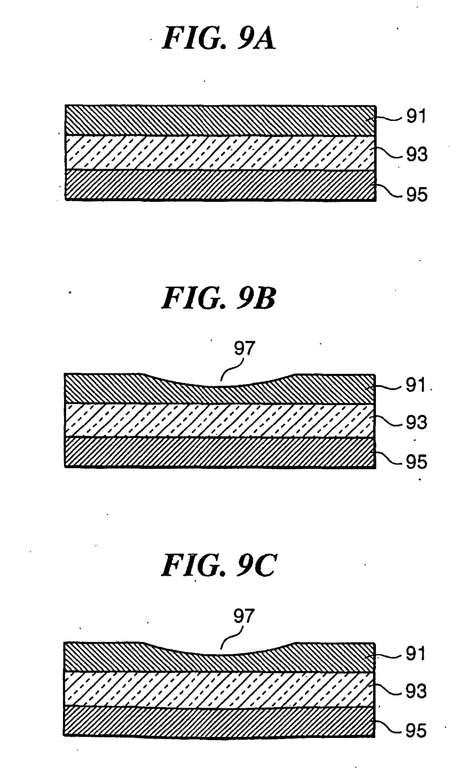

The conventional method for controlling the reflective wave front by scraping the multi-layered film will be explained referring to Fig.9. As shown in Fig.9A, a Mo/Si multi-layered film 91 and 95 are formed on the both surfaces of the plane substrate 93 respectively. Because of forming the multi-layered films on both surfaces of the substrate, the deformation caused by the stress of the multi-layered film on one surface of the substrate is canceled with the deformation caused by the stress of the multi-layered film on another surface of the substrate so that the substrate shape is maintained to be plane. The Mo/Si multi-layered film. is composed of 50 layer pairs having a periodic length of 6.8.nm and $\Gamma$ of 0.35, and 10 layer pairs having a period length of 6.8 nm and $\Gamma$ of 0.1 which are formed on the former formed Mo/Si multi-layered film. The multi-layered film is formed by an ion beam sputtering method. $\Gamma$ is a division ratio of a layer structure unit, and shows a ratio of a thickness of a substance having a larger absorptance to a periodic length. Here, it is a ratio of a thickness of the Mo layer to the periodic length of 6.8nm. The reason why 10 layer pairs having $\Gamma$ of 0.1 are formed on the most upper surface is to improve the control precision of the wave front subjected to the scraping process for the multi-layered film. By scraping one layer pair from the multi-layered film, the optical path length is lengthened with 0.05nm, so the reflective wave front is delayed with 0.1 nm at both of incidence and reflection. The principle has already been described above. So, as shown in Fig. 9B, when scraping a part 97 from the multi-layered film, the shape of the reflective wave front can be controlled with a high shape precision by adjusting the scraping amount in the reflective surface. However, since the Mo/Si multi-layered film has a compressive stress of -450 MPa, the thickness of the multi-layered film where the part of the multi-layered film is scraped locally becomes uneven so that the balance between the total stresses( stress × thickness) on the both surfaces of the substrate is lost, and the shape of the substrate becomes to be uneven, as shown in Fig.9C. In the case that a part of a Mo/Si multi-layered film is scraped off, the scraped film has a compressive stress so that a part where the scraped film is formed on the substrate is deformed to concave. As the result, the reflective-surface is further delayed with larger length than that predicted by the effect of the scraping, whereby the wave front can not be controlled with a desirable precision.

The wave front shape after the multi-layered film is locally scraped is dependent on not only the change in the optical path length of the reflective light due to the scraped multi-layered film, as described above, but also the deformation of the substrate due to the unevenness of the total Stress of they multi-layered film. Accordingly, in order to achieve a desirable shape precision of the reflective wave front by scraping the multi-layered film locally, there is a problem that it is not enough to determine the scraping amount based on the change in the optical path length of the reflective light due to the scraped multi-layered film only.

The present invention has been made to solve the above-described problems, and has an object to provide a method for manufacturing for a multi-layered film reflection mirror capable of obtaining a desirable reflection wave front after scraping the multi-layered film.

DISCLORSURE OF THE INVENTION

A method for manufacturing a 'multi-layered film reflection mirror according to claim 1 of the present invention is provided, in which a multi-layered film which at least two types of substances having different refractive indices respectively are synchronously deposited with a constant periodic length is formed on a substrate, and the multi-layered film on the substrate is locally scraped in order to correct a phase of a reflective wave front in a reflective surface, wherein said multi-layered film has an internal stress of 50 MPa or less.

And, it is preferable that the multi-layered film is a film which Mov/Ru/Mo/Si layers are deposited, and an ion beam is irradiated to a surface after forming each Mo layer.

According to the claim 1 of the present invention, since the multi-layered film which is locally scraped in order to correct a phase of a reflective wave front has an internal stress of 50 MPa or less, a change in the total stress( stress $\times$ film thickness) due to the scraping of the multi-layered film can be decreased. Therefore, the reflective wave front can be controlled with a high precision after scraping the multi-layered film.

A method for manufacturing a multi-layered film reflection mirror according to the claim 3 is provided, in which a multi-layered film which at least two types of substances having different refractive indices respectively are synchronously deposited with a constant periodic length is formed on a substrate, and the multi-layered film on the substrate is locally scraped in order to correct a phase of a reflective wave front in a reflective surface, wherein a film or a multi-layered film is formed on a back surface of the substrate in order to produce a deformation of the substrate capable of canceling a deformation of the substrate caused by scraping the multi-layered film

According to the claim 3 of the present invention, since a film or a multi-layered film is formed on a back surface of the substrate in order to produce a deformation of the substrate capable of canceling a deformation of the substrate caused by scraping the multi-layered film, the shape of the substrate can be kept to the shape prior to the scraping process of the multi-layered film. Therefore, the reflective wave front can be controlled with a high precision after scraping the multi-layered film.

A method for manufacturing a multi-layered film reflection mirror according to the claim 4 of the present invention, is provided, in which a multi-layered film which at least two types of substances having different refractive indices respectively are synchronously deposited with a constant periodic length is formed on a substrate, and the multi-layered film on the substrate is locally scraped in order to correct a phase of a reflective wave front in a reflective surface, wherein a multi-layered film having a approximately same structure as that of the multi-layered film formed on the surface of the substrate is formed on a back surface of the substrate, and the multi-layered film formed on the back surface of the substrate is locally scraped at portions correspondent to the portions where the multi-layered film on the surface of the substrate is locally scraped in order to correct a phase of a reflective wave front with a same thickness as that of the scraped multi-layered film on the surface of the substrate.

According to the claim 4 of the present invention, the total stresses on both surfaces of the substrate are canceled so that the shape of the substrate can be kept to the shape prior to the scraping process of the multi-layered film. Therefore, the reflective wave front can be controlled with a high precision after scraping the multi-layered film.

A method for manufacturing a multi-layered film reflection mirror according to claim 5 of the present invention is provided, in which a multi-layered film which at least two types of substances having different refractive indices respectively are synchronously deposited with a constant periodic length is formed on a substrate, and the multi-layered film on the substrate is locally scraped in order to correct a phase of a reflective wave front in a reflective surface, wherein a scraping amount of the multi-layered film is determined based on an influence of a deformation of the substrate caused by scraping the multi-layered film.

According to the claim 5 of the present invention, since a scraping amount of the multi-layered film is determined based on an influence in a deformation of the substrate caused by scraping the multi-layered film, the reflective wave front can be controlled with a high precision after scraping the multi-layered film.

A method for manufacturing a multi-layered film reflection mirror according to claim 6 of the present invention is provided, in which a multi-layered film which at least two types of substances having different refractive indices respectively are synchronously deposited with a constant periodic length is formed on a substrate, and the multi-layered film on the substrate is locally scraped in order to correct a phase of a reflective wave front in a reflective surface, wherein a scraping amount of the multi-layered film is determined so that a phase combining a phase of the reflective wave front, which is modified by a deformation of the substrate caused by scraping the multi-layered film, and a phase of the reflective wave front, which is modified by locally scraping the multi-layered film, becomes equal to a desirable correcting amount.

According to the claim 6 of the present invention, since a scraping amount is determined based on a phase of a reflective wave front which is modified by a deformation of the substrate caused by scraping the multi-layered film, the reflective wave front can be controlled with a high precision after scraping the multi-layered film.

Also, the method for manufacturing a multi-layered film reflection mirror according to claim 7 is provided, in which the multi-layered film may comprise a layer containing a Mo and a layer containing a Si.

According to the claim 7 of the present invention a phase of the reflective wave front of the reflection mirror having a large reflectivity in a wavelength band of 12.5 nm to 14 nm can be controlled with a high precision.

Also, the method for manufacturing a multi-layered film reflection mirror according to claim 8 is provided in which a substance containing Si may be formed on a reflective surface of the substrate from which the multi-layered film is scraped.

According to the claim 8 of the present invention, it is possible to prevent the oxidation of a layer except the Si layer. So, the reflective wave front can be controlled with a high precision after scraping the multi-layered film while the change in characteristics of the reflection mirror due to oxidation is prevented.

## BRIEF DESCRIPTION OF THE DRAWINGS

Fig.1A and 1B are cross-sectional drawings showing a manufacturing process for a multi-layered film reflection mirror according to an embodiment of the present invention.

Fig.2A to 2C are cross-sectional drawings showing a manufacturing process for a multi-layered film reflection mirror according to another embodiment of the present invention.

Fig.3A to 3C are cross-sectional drawings showing a manufacturing process for a multi-layered film reflection mirror according to another embodiment of the present invention.

Fig.4A to 4C are cross-sectional drawings showing a manufacturing process for a multi-layered film reflection mirror according to another embodiment of the present invention.

Fig. 5 is a cross-sectional drawing showing a manufacturing process for a multi-layered film reflection mirror according to the first example of the present invention.

Fig. 6 is a cross-sectional drawing showing the second example of the present invention.

Fig.7 is a cross-sectional drawing showing the third example of the present Invention.

Fig.8A, 8B are cross-sectional drawings explaining a principle for controlling a wave front by scraping a multi-layered film.

Fig.9A to 9C are cross-sectional drawings explaining a method for controlling the reflection wave front by a conventional multi-layered film scraping.

## BEST MODE FOR CARRYING-OUT OF THE INVENTION

Reference will be described in detail with reference to drawings. Here, the drawings described-below are schematic drawings and the ratio of a thickness of a substrate to a periodic length of a multi-layered film; a scraping amount of a multi-layered film, and the like are not always correct.

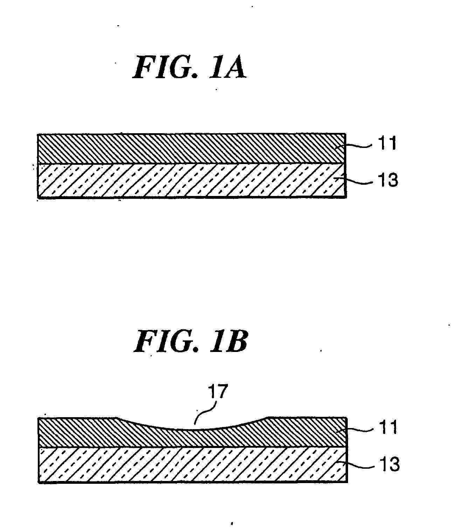

Fig.1A and 1B are cross-sectional drawings showing a manufacturing process for a multi-layered film reflection-mirror according to an embodiment the present invention.

As shown in Fig.1A, a Mo/Ru/Mo/Si multi-layered film 11 is formed on a plane substrate 13. The multi-layered film 11 is composed of two types of substances ( two types of substances comprising of Mo/Ru/Mo and Si) having different refractive indices respectively which are deposited alternatively with a constant periodic length. On the forming the multi-layered film, an ion beam is irradiated after forming each Mo layer. The multi-layered film has an internal stress of +14 MPa.

Since such internal stress is about 1/30 of that of a conventional multi-layered film which has an internal stress of -450 MPa( compressive), the deformation in the substrate caused by the formed multi-layered film is so small that the shape of the substrate can be assumed to be a plane even if the multi-layered film is formed.

The Mo/Ru/Mo/Si multi-layered film is composed of 50 layer pairs having a period length of 6.8 nm and $\Gamma$ of 0.35, and 10 layer pairs having a period length of 6.8 nm and $\Gamma$ of 0.1 which are formed on the Mo/Ru/Mo/Si multi-layered film. The multi-layered film is formed by an ion beam sputtering method. The $\Gamma$ is a division

ratio of a layer structure unit, and shows a ratio of a thickness of a substance having a larger absorbance to a period length. Here, it is a ratio of a sum of a thickness of the Mo layer and a thickness of the Ru layer to the periodic length. The reason why the 10 layer pairs having Γ of 0.1 are formed on the most upper surface is to improve the control precision for the wave front subjected to a scraping process of the multi-layered film, as similar to the conventional embodiment as shown in Fig. 9. Since optical constants of Mo and Ru in a wavelength in the vicinity of 13 nm are nearly, the effect of controlling the wave front by the scraping process of the Mo/Ru/Mo/Si multi-layered film is similar to that of the Mo/Si multi-layered film. By scraping one layer pair from the multi-layered film, the optical path length is lengthened with 0.05 nm, so the reflective wave front is delayed with 0.1nm at both of incidence and reflection . Therefore , as shown in Fig.1B, if a part 17 of the multi-layered film is scraped off, it is possible to control a shape of the reflective wave front with a high precision by adjusting the scraping amount in the reflective surface. In addition, stress of the Mo/Ru/Mo/Si multi-layered film is so small that the shape of the substrate is not deformed by the unevenness in the total stress so as to be kept plane even if the multi-layered film is locally scraped off. Accordingly, the scraping process of the multi-layered film enables to control the reflective wave front with a high shape precision.

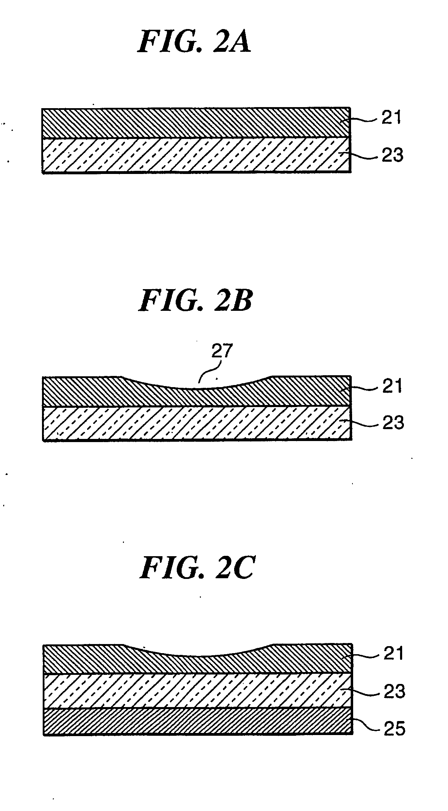

Next, a process for manufacturing a multi-layered film reflection mirror according to another embodiment of the present invention referring to Fig.2 to Fig.4.

In Fig. 2, from a substrate 23( Fig.2A) on which a Mo/Si multi-layered -film 21 is formed, a part 27 of the multi-layered film 21 is scraped in order to control a wave front( ( Fig.2B). In this state, the scraped film has a compressive stress so that a part of the substrate where the film is scraped off is deformed to concave. Then, in order to cancel the deformation, another multi-layered film 25 is formed on a back surface of the substrate so as to produce a deformation capable of canceling the deformation caused by the scraping process ( Fig.2C). Thus , the shape of the substrate is kept the shape before the multi-layered film is locally scraped off. While the multi-layered film is formed on one surface of the substrate in the above-described example, the present invention will be applied to the case that the multi-layered films are formed on both surfaces of the substrate. And, in the present embodiment, while a multi-layered film is formed on a back surface of a reflective surface, a single-layer film may be formed on a back surface of a reflective surface if the distribution of the total stress in the surface is approximately similar to that on a surface.

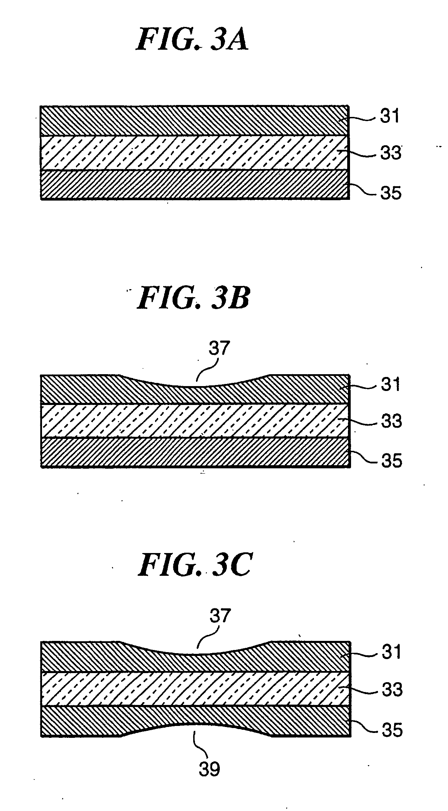

In Fig.3, Mo/Si multi-layered films 31 and 35 are formed on both surfaces of a substrate 33, respectively( Fig.3A). A part 37 of the multi-layered film 31 is scraped in order to control the wave front( Fig. 3B), and then a part 39 of the multi-layered film 35 on the back surface is scraped with the same distribution as that of the multi-layered film 31 on the surface( Fig.3C) . As the result, the distribution in the total stress of the multi-layered film on the surface is canceled with that on the back surface even after the multi-layered film is scraped off, whereby the substrate is not deformed. Therefore, the reflective wave front can be controlled with a high precision.

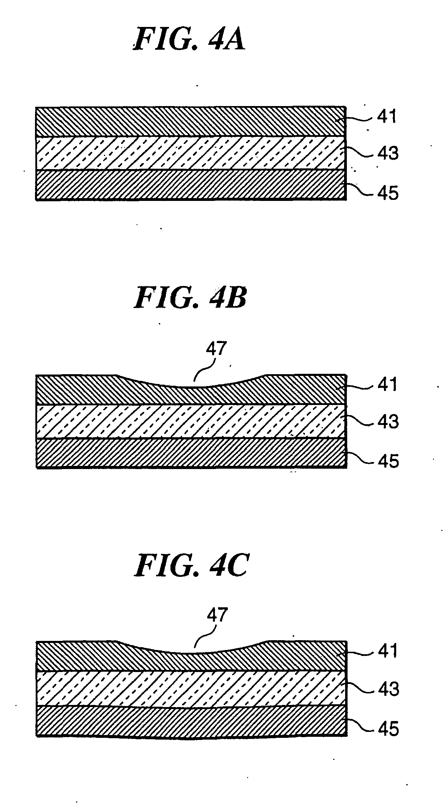

In Fig. 4, Mo/Si multi-layered films 41 and 45 are formed on both surfaces of the substrate 43, respectively (Fig.4A). In this embodiment, based on the deformation of the substrate caused by the total stress distribution in the wave front surface due to the scraping a part 47 of the multi-layered film 41, the scraping amount of the multi-layered film 41 is determined( Fig.4B) . In the case of a Mo/Si multi-layered film, since a part of the substrate where the film is scraped. off is deformed to concave( ( Fig.4C), the scraping amount of the multi-layered film is reduced compared with that of the case that there is no substrate deformation.

That is, when a part of the substrate where the film is scraped off is deformed to concave, the scraping amount of the multi-layered film is determined based on a phase of a reflective wave front in the reflective surface which is modified by the substrate deformation. Accordingly, the phase combining the phase of the reflection wave front, which will be modified by the substrate deformation, and the phase of the reflection wave front, which will be modified by scraping the part of the multi-layered film, becomes equal to a desirable correcting amount.

And, in the above-described-method for manufacturing a multi-layered film reflection mirror, it is preferable that a substance containing Si is formed on a reflective surface of a substrate after scraping the multi-layered film for wave front control. Hereby, an oxidation of the layer except the Si layer can be prevented. So, the change in the property of the reflection mirror due to the oxidation can be prevented, and the reflection wave front can be controlled with a high precision by scraping the multi-layered film.

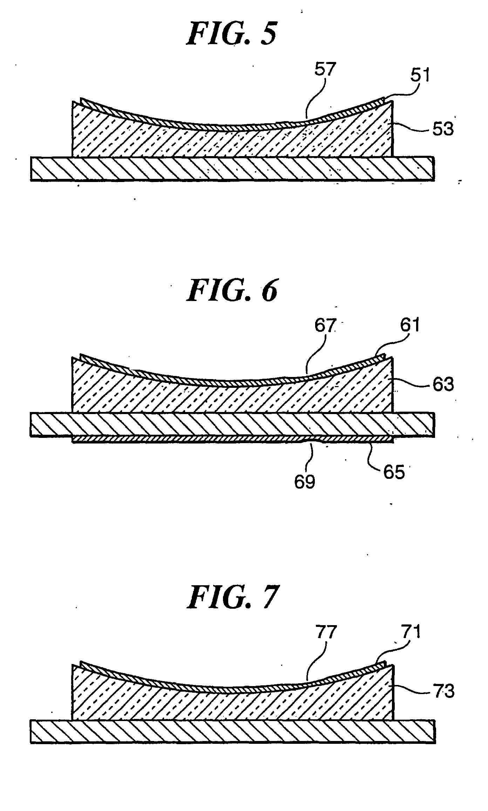

( Example 1) A first example according to the present invention will be described referring to Fig. 5. On a substrate 53 made of the low thermal expansion glass processed to aspheric, a Mo/Ru/Mo/Si multi-layered film 51 is formed. At the forming the multi-layered film, an ion beam is irradiated after forming each Mo layer. The stress of the multi-layered film is + 14 MPa or less. Concerning the irradiation condition of the ion beam in order to achieve to have such low stress, for instance, an ion source is Argon( $Ar^+$) , an acceleration voltage is 600v, an ion current density is 0.5 mA/cm$^2$, and an ion beam irradiating time is 2 second, preferably. Incidentally, the stress in the multi-layered film is evaluated by using a deformation amount of the Si wafer substrate, which is caused by the film forming on the wafer.

The stress of the multi-layered film is about 1/30 of that of a conventional Mo/Si multi-layered film which has an internal stress of -450, MPa ( compressive), and other components except for the component which causes a change in the radius of curvature of the substrate among the component which causes a deformation of the substrate by the multi-layered film forming is very little. As for the reason, it is confirmed by the calculation of the substrate deformation simulation using the finite element method. The shape precision of the aspheric surface of the substrate' after forming the multi-layered film is .0.5 nm RMS.

The multi-layered film is composed of 50 layer pairs having a period length of 6.,8 nm and $\Gamma$ of 0.35, and 10 layer pairs having a period length of 6.8 nm and $\Gamma$ of 0.1 which are formed on the former multi-layered film. The multi-layered film is formed by an ion beam sputtering method. According to the result of measurement of the wave front, the reflective wave front is needed to delay at a part in the right side of the figure. Then, the most upper layer having $\Gamma$ of 0.1 is scraped off with controlling the scraping amount. By scraping a part 57 of the multi-layered film, the shape precision in the reflective wave front is reduced to 0.15 nm RMS. Also, since the Mo/Ru/Mo/Si multi-layered film has small stress, even if the part of the multi-layered film is scraped off, the substrate deformation caused by the unevenness of the total stress is not occurred. So, the scraping process of the multi-layered film makes it possible to control the reflective wave front with a high precision. The fact that the Mo/Ru/Mo/Si multi-layered film has a small stress is confirmed by evaluation of the deformation amount of the wafer substrate caused by forming a Mo/Ru/Mo/Si multi-layered film on the silicon wafer.

In the present example, the multi-layered film is scraped off by means of an ion beam irradiation. Concerning the ion beam irradiation condition at this time, for instance, an ion source is Argon( Ar+), the acceleration voltage is 600 V, an ion current density is 0.5 mA/cm2, and ion beam irradiating time is 2 second, preferably.

In the present example, the Mo/Ru/Mo/Si multi-layered film in which an ion beam is irradiated after forming each Mo layer is used as a multi-layered film having a low stress, and the kinds of the multi-layered film is not limited by this and may be a multi-layered film having a high ref lectivity in a wavelength of 11 to 14 nm and a small stress. The stress in the multi-layered film is whether compressive stress or tensile stress and may be 50 MPa or less, preferably. Because, when the stress in the multi-layered film is over 50 MPa, the deformation component which can not be canceled by adjusting the distance between the mirrors will be 1 nm or more thereby to affect the EUV lithography.

And, in the present example, while the multi-layered film is scraped by irradiation of an ion beam, the multi-layered film scraping method is not limited by this. As another multi-layered film scraping method, a dry etching method or a method using an abrasive may be employed when a desirable scraping amount can be obtained at any portion on the multi-layered film.

(Example 2) A second example according to the present invention will be described referring to Fig. 6. On a surface and a back surface of a substrate 63 made of a low thermal expansion glass processed to aspheric, Mo/Si multi-layered films 61 and 65 are formed, respectively. The shape precision of the aspheric substrate is 0.5 nm RMS . Here, since the multi-layered films are formed on both surfaces of the substrate, the substrate deformation caused by the stress in the multi-layered film at the surface is canceled with that on the back surface of the substrate, so that the shape precision of the substrate is kept. The Mo/Si multi-layered film is composed of 50 layer pairs having a period length of 6.8nm and $\Gamma$ of 0.35, and 10 layer pairs having a period length of 6 . 8nm and $\Gamma$ of 0.1 which are formed on the former multi-layered film. The multi-layered film is formed by an ion beam sputtering method. According to the result of the measurement of the wave front, the reflective wave front is needed to delay at a part in the right side of the figure. Then, the most upper layer having $\Gamma$ of 0.1 is locally scraped off with controlling the scraping amount. By scraping a part 67 of the multi-layered film, the shape precision in the reflection wave front can be reduced to 0.15 nm RMS. However, since the Mo/Si multi-layered film has a compressive stress of -450 MPa, the total stress in the multi-layered film 61 becomes uneven after scraping a part of the multi-layered film locally and the shape of the substrate is different from that before the scraping process. In order to cancel the difference, a part 69 of the multi-layered film on the back surface of the substrate is also scraped at portions correspondent to the scraped part 67 of the multi-layered film on the surface of the substrate. The film thickness distribution of the scraped multi-layered film on the back surface coincides with the total film thickness distribution of the multi-layered film 61 on the reflective surface. Accordingly, the total stress produced on the reflective surface of the substrate is canceled with the total stress produced on the back surface thereof, so that the substrate 63 is not deformed to be able to control the reflective wave front with a high precision.

In the present example, while the Mo/Si multi-layered film having a compressive stress is formed on the back surface of the reflective wave front, the multi-layered film on the back surface is not limited by the Mo/Si multi-layered film even if the total stress distribution in the back surface is almost the same as that at the surface. Also, it may be a single-layered film. And, in the present example, while a film having a compressive stress is formed on the back surface, a film having a tensile stress such as Mo/Be multi-layered film may be used. In this case, the film thickness is controlled by the reverse order in the case of the film having a compressive stress. And, the scraping process of the multi-layered film may start from either the surface of the substrate or and the back surface thereof. And, in the present example, while the multi-layered film is formed by an ion beam sputtering, the multi-layered film forming method is not limited by this method, and a magnetron sputtering method or a vapor deposition method may be used.

(Example 3)

A third example according to the present invention will be described referring to Fig. 7. A Mo/Si multi-layered film 71 formed on a reflective surface of a substrate 73 made of the low thermal expansion glass has a same structure as that of the multi-layered film of the second example, and will not be explained in detail. According to the result of the measurement of the reflective wave front of the substrate, the wave front is needed to delay. with most 0.6 nm at the part in the right side of the figure. Then, 4 layer pairs are scraped from a part 77 of the multi-layered film in the right side of the figure. Hereby, the optical length of a EUV light beam to the scraped part 77 of the multi-layered film is 0 . 2 nm longer than that before scraping. And, the reflective light is passed to the part 2 times of the incidence and the reflection so that the wave front is delayed with 0.4 nm. On the other hand, locally scraping the multi-layered film produces an in-plane distribution of the total stress in the Mo/Si multi-layered film. Since the Mo/Si multi-layered film has a compressive stress, a part of the substrate where the film thereon is scraped is deformed to concave to the bottom direction in the figure. The deformation amount is 0.1 nm in the present example. Due to the deformation also, the wave front is delayed-at the part where the multi-layered film thereon is scraped. The delay is 0.2 nm, in the example. So, in the present example, as the result that 4 layer pairs of the multi-layered film is scraped, by using the variation in the optical length by scraping the multi-layered film, and the variation in the substrate shape by locally scraping the multi-layered film, the needed delay of the wave front of 0.6 nm can be achieved, so a desirable precision of the reflective wave front can be obtained.

As mentioned above, while the methods for manufacturing a multi-layered film reflection mirror according to the embodiment of the present invention have been described, the present invention is not limited by this and may add various changes in the range which does not deviate from the point of this invention.

As previously described, according to the present embodiments and examples, in a method manufacturing for a multi-layered film reflection mirror is provided, in which one layer pair is scraped from the film one by one in order to correct a shape of a reflective wave front, the influence of the substrate deformation caused by the scraping the film having an internal stress can be suppressed. As the result, the shape of the wave front can be corrected with a higher precision to reduce the wave front aberration, whereby the focusing property can be improved.

**Claims**

1. A method for manufacturing a multi-layered film reflection mirror, in which a multi-layered film which at least two types of substances having different refractive indices respectively are synchronously deposited with a constant periodic length is formed on a substrate, and
   the multi-layered film on the substrate is locally scraped in order to correct a phase of a reflective wave front in a reflective surface,
   wherein said multi-layered film has an internal stress of 50 MPa or smaller.

2. The method for manufacturing a multi-layered film reflection mirror according to claim 1, wherein the multi-layered film is a film which Mo/Ru/Mo/Si layers are deposited, and an ion beam is irradiated to a surface after forming each Mo layer.

3. A method for manufacturing a multi-layered film reflection mirror, in which a multi-layered film which at least two types of substances having different refractive indices respectively are synchronously deposited with a constant periodic length is formed on a substrate, and
   the multi-layered film on the substrate is locally scraped from in order to correct a phase of a reflective wave front in a reflective surface,
   wherein a film or a multi-layered film is formed on a back surface of the substrate in order to produce a deformation of the substrate capable of canceling a deformation of the substrate caused by scraping the multi-layered film.

4. A method for manufacturing a multi-layered film reflection mirror, in which a multi-layered film which at least two types-of substances having different refractive indices respectively are synchronously deposited with a constant periodic length is formed on a substrate, and
   the multi-layered film on'the substrate is locally scraped from in order to correct a phase of a reflective wave front in a reflective surface,
   wherein a multi-layered film having an approximately same structure as that of the multi-layered film formed on the surface of the substrate is formed on a back surface of the substrate, and
   the multi-layered film formed on the back surface of the substrate is locally scraped at portions correspondent to the portions where the multi-layered film on the surface of the substrate is locally scraped in order to correct a phase of a reflective wave front with a same thickness as that of the scraped multi-layered film on the surface of the substrate.

5. A method for manufacturing a multi-layered film reflection mirror, in which a multi-layered film which at least two types of substances having different refractive indices respectively are synchronously deposited with a constant periodic length is formed on a substrate; and

the multi-layered film on the substrate is locally scraped in order to correct a phase of a reflective wave front in a reflective surface,

wherein a scraping amount of the multi-layered film is determined based on an influence in a deformation of the substrate caused by scraping the multi-layered film.

6. A method for manufacturing a multi-layered film reflection mirror, in which a multi-layered film which at least two types of substances having different refractive indices. respectively are synchronously deposited with a constant periodic length is formed on a substrate, and

the multi-layered film on the substrate is locally scraped in order to correct a phase of a reflective wave front in a reflective surface,

wherein a scraping amount of the multi-layered film is determined so that a phase combining a phase of the reflective wave front, which is modified by a deformation of the substrate caused by scraping the multi-layered film, and a phase of the reflective wave front, which is modified by locally scraping the multi-layered film, becomes equal to a desirable correcting amount.

7. The method for manufacturing a multi-layered film reflection mirror according to one of claims 1 to 6 , wherein the multi-layered film comprises a layer containing a Mo and a layer containing a Si.

8. The method manufacturing for a multi-layered film. reflection mirror according to one of claims 1 to 7, wherein a substance containing Si is formed on a reflective surface of the substrate from which the multi-layered film is scraped.

# *FIG. 1A*

— 11
— 13

# *FIG. 1B*

17
— 11
— 13

# FIG. 2A

21

23

# FIG. 2B

27

21

23

# FIG. 2C

21

23

25

## FIG. 3A

## FIG. 3B

## FIG. 3C

## FIG. 4A

41
43
45

## FIG. 4B

47

41
43
45

## FIG. 4C

47

41
43
45

## FIG. 5

## FIG. 6

## FIG. 7

# FIG. 8A

# FIG. 8B

## FIG. 9A

91
93
95

## FIG. 9B

97
91
93
95

## FIG. 9C

97
91
93
95

## INTERNATIONAL SEARCH REPORT

| International application No. |
| --- |
| PCT/JP02/01712 |

**A. CLASSIFICATION OF SUBJECT MATTER**
Int.Cl$^7$ G21K1/06, H01L21/027

According to International Patent Classification (IPC) or to both national classification and IPC

**B. FIELDS SEARCHED**

Minimum documentation searched (classification system followed by classification symbols)
Int.Cl$^7$ G21K1/06, H01L21/027

Documentation searched other than minimum documentation to the extent that such documents are included in the fields searched

| | | | |
| --- | --- | --- | --- |
| Jitsuyo Shinan Koho | 1922–1996 | Toroku Jitsuyo Shinan Koho | 1994–2002 |
| Kokai Jitsuyo Shinan Koho | 1971–2002 | Jitsuyo Shinan Toroku Koho | 1996–2002 |

Electronic data base consulted during the international search (name of data base and, where practicable, search terms used)
JICST

**C. DOCUMENTS CONSIDERED TO BE RELEVANT**

| Category* | Citation of document, with indication, where appropriate, of the relevant passages | Relevant to claim No. |
| --- | --- | --- |
| Y<br>A | M. YAMAMOTO, "Sub-nm figure error correction of an extreme ultraviolet multiplayer mirror by its surface milling", In: Nuclear Instruments & Methods in Physics Research, 7th International Conference on Synchrotron Radiation Instrumentation, Berlin Germany, 21 to 25 August, 2000 (21-25.08.00) | 1-3,7,8<br>4-6 |
| Y | M. SHIRAISHI et al., "Stress reduction of molybdenum/silicon multilayers deposited by ion-beam sputtering", In: Proceedings of SPIE 3997, pages 620 to 627, 28 February, 2000 (28.02.00) to 01 March, 2000 (01.03.00) | 1,2,7,8 |
| Y | JP 7-280999 A (Nikon Corp.), 27 October, 1995 (27.10.95), Full text; Figs. 1 to 2 | 3,7,8 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 20 May, 2002 (20.05.02) | 04 June, 2002 (04.06.02) |

| Name and mailing address of the ISA/ | Authorized officer |
| --- | --- |
| Japanese Patent Office | |
| Facsimile No. | Telephone No. |

Form PCT/ISA/210 (second sheet) (July 1998)

18

**EP 1 378 918 A1**

<table>
<tr><td colspan="2"><strong>INTERNATIONAL SEARCH REPORT</strong></td><td>International application No.<br>PCT/JP02/01712</td></tr>
</table>

| C (Continuation). DOCUMENTS CONSIDERED TO BE RELEVANT | | |
|---|---|---|
| Category* | Citation of document, with indication, where appropriate, of the relevant passages | Relevant to claim No. |
| Y | JP 8-293450 A  (Nikon Corp.),<br>05 November, 1996 (05.11.96),<br>Full text; Figs. 1 to 4 | 8 . |

Form PCT/ISA/210 (continuation of second sheet) (July 1998)

19